(19) Europäisches Patentamt
European Patent Office
Office européen des brevets

(11) **EP 0 508 805 B1**

(12) **EUROPEAN PATENT SPECIFICATION**

(45) Date of publication and mention
of the grant of the patent:
**26.11.1997 Bulletin 1997/48**

(51) Int Cl.$^6$: **H03H 17/04**, H03H 17/02

(21) Application number: **92303206.4**

(22) Date of filing: **10.04.1992**

(54) **Cyclic digital filter**

Zyklisches digitales Filter

Filtre numérique cyclique

(84) Designated Contracting States:
**DE FR GB**

(30) Priority: **12.04.1991 JP 108736/91**
**24.10.1991 JP 305478/91**

(43) Date of publication of application:
**14.10.1992 Bulletin 1992/42**

(73) Proprietor: **SONY CORPORATION**
**Tokyo 141 (JP)**

(72) Inventor: **Sakamoto, Etsurou,**
**c/o Patents Division**
**Shinagawa-ku, Tokyo 141 (JP)**

(74) Representative: **Pilch, Adam John Michael et al**
**D. YOUNG & CO.,**
**21 New Fetter Lane**
**London EC4A 1DA (GB)**

(56) References cited:
**US-A- 4 972 356**

• **SIGNAL PROCESSING IV: THEORIES AND APPLICATIONS vol. 2, 5 September 1988, GRENOBLE, FR pages 755 - 758 , XP124742 KWAN ET AL 'efficient high speed delayed multipath one-dimensional recursive digital filter architecture'**
• **ELECTRONICS LETTERS. vol. 25, no. 15, 20 July 1989, ENAGE GB pages 982 - 983 , XP72014 KANEKO 'alternative implementation of systolic recursive digital filters'**

Remarks:
The file contains technical information submitted after the application was filed and not included in this specification

## Description

The present invention relates to a digital filtering circuit (filter) and, more particularly, to a cyclic (or recursive) digital filter.

US-A-4 972 356 discloses cyclic digital filters having an input, an adder for adding an input signal to a feedback signal to produce a filter output signal, and delay means for delaying the output signal. The feedback signal is produced by one or more parallel feedback stages each including at least a unit time delay, a coefficient multiplier and a stage adder which adds the output of the multiplier to the output of the next lower stage.

The general transfer function H(z) for cyclic digital filters is expressed by Equation (1):

$$H(z) = \frac{\sum_{\mu=0}^{M} a_\mu \cdot z^{-\mu}}{1 + \sum_{\nu=1}^{N} b_\nu \cdot z^{-\nu}} \qquad (1)$$

where N is greater than M. Suitably developing the transfer function H(z) allows various types of cyclic digital filter to be constructed. Cyclic digital filters generally fall into three types: direct cyclic digital filters, parallel cyclic digital filters, and cascade cyclic digital filters.

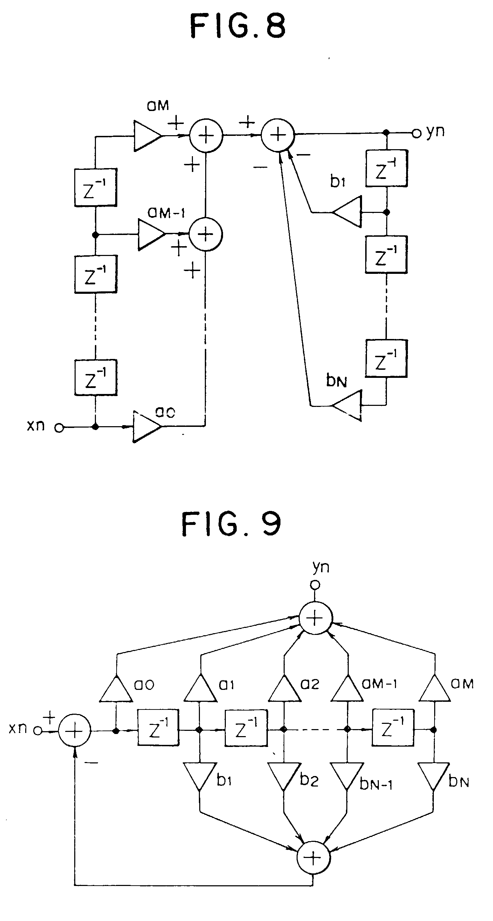

Figures 8 and 9 show the theoretical structures of direct cyclic digital filters. Figure 8 illustrates a direct cyclic digital filter in which N is greater than M. For this filter, the transfer function H(z) addressing an output signal $y_n$ with respect to an input signal $x_n$ is duly expressed by Equation (1).

In Figure 8, an encircled plus (+) sign stands for an adder that performs add or add-subtract operations, a triangle for a coefficient multiplier that multiplies an input signal by a coefficient, and a rectangle for a unit time delay circuit that provides a unit time delay. The symbol $x_n$ represents an input signal, and the symbol $y_n$ represents an output signal. The unit delay time of the unit-time delay circuit generally corresponds to one clock pulse.

Figure 9 depicts the theoretical structure of a direct cyclic digital filter in which N is equal to M. The transfer function H(z) in effect at this time is also expressed by Equation (1).

In Figure 9, as in Figure 8, an encircled plus (+) sign stands for an adder, a triangle for a coefficient multiplier, and a rectangle for a unit time delay circuit. The symbol $x_n$ represents an input signal, and the symbol $y_n$ represents an output signal.

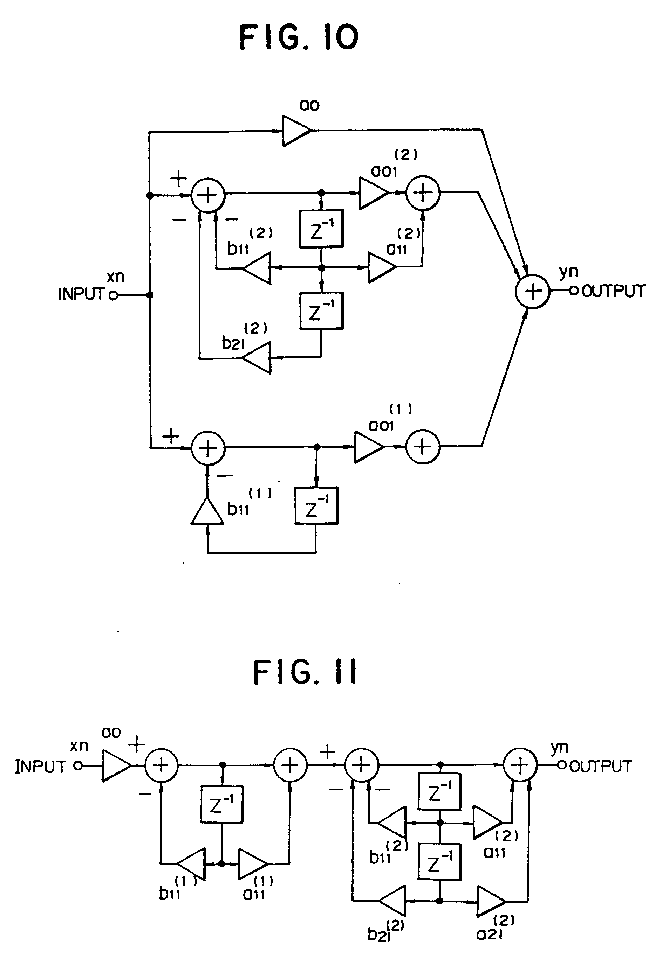

Figure 10 shows the theoretical structure of a typical parallel cyclic digital filter. In Figure 10, as in Figure 8, an encircled plus (+) sign stands for an adder, a triangle for a coefficient multiplier, and a rectangle for a unit time delay circuit. The symbol $x_n$ represents an input signal, and the symbol $y_n$ represents an output signal. If N equals M, the transfer function H(z) for this filter is expressed by Equation (2):

$$H(z) = \sum_{k=1}^{K} H_k(z)$$

$$= a_0 + \sum_{k=1}^{K_1} \frac{a_{0k}^{(1)}}{1 + b_{1k}^{(1)} z^{-1}} + \sum_{k=1}^{K_1} \frac{a_{0k}^{(2)} + a_{1k}^{(2)} z^{-1}}{1 + b_{1k}^{(2)} z^{-1} + b_{2k} z^{-2}} \qquad (2)$$

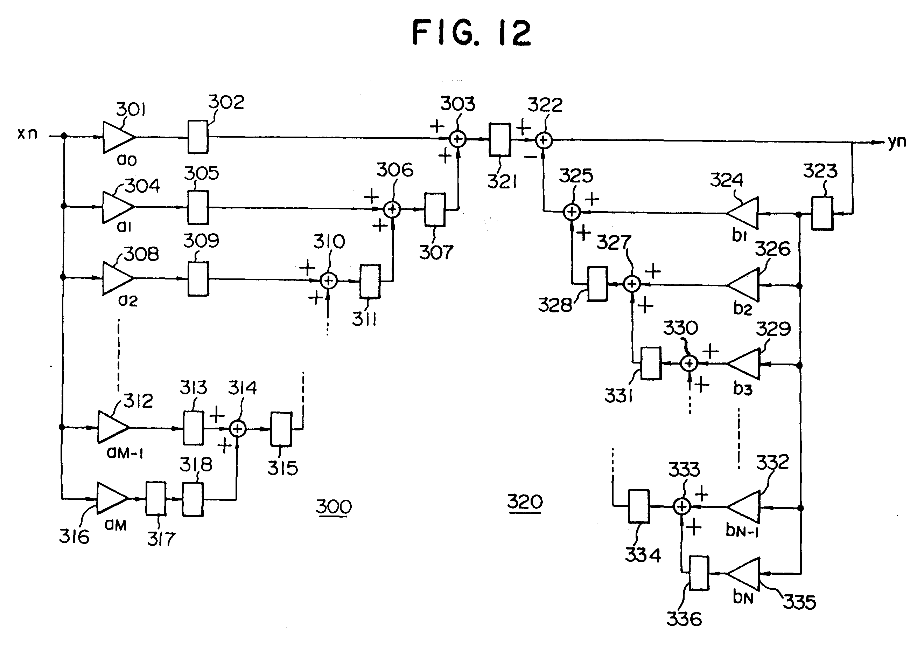

Figure 11 illustrates the theoretical structure of a cascade cyclic digital filter. In Figure 11, as in Figure 8, an encircled plus (+) sign stands for an adder, a triangle for a coefficient multiplier, and a rectangle for a unit time delay circuit. The symbol $x_n$ represents an input signal, and the symbol $y_n$ represents an output signal. The transfer function for this filter is expressed by Equation (3):

$$H(z) = \prod_{k=1}^{K} H_k(z)$$

$$= a_0 \prod_{k=1}^{K_1} \frac{1 + a_{1k}^{(1)} z^{-1}}{1 + b_{1k}^{(1)} z^{-1}} \prod_{k=1}^{K_2} \frac{1 + a_{1k}^{(2)} z^{-1} + a_{2k}^{(2)} z^{-2}}{1 + b_{1k}^{(2)} z^{-1} + b_{2k}^{(2)} z^{-2}} \qquad (3)$$

For the direct cyclic digital filter whose theoretical structure is shown in Figure 8, assume that T1 stands for the time required to multiply the filter coefficients, and T2 for the time required for two-input, one-output addition and subtraction. In that case, a practical circuit for high-speed operation may be constructed as shown in Figure 12.

The cyclic digital filter of Figure 12 is a direct cyclic filter comprising a feed-forward circuit 300 and a feedback loop circuit 320 connected in series.

The feed-forward circuit 300 comprises a first feed-forward circuit, a second feed-forward circuit, a third feed-forward circuit, ..., an M-th feed-forward circuit, and an (M+1)th feed-forward circuit. The first feed-forward circuit comprises a coefficient multiplier 301 that multiplies the input signal $x_n$ by a filter coefficient $a_o$; a unit time delay circuit 302 that delays the result of the multiplication by one clock pulse; and an adder 303 that adds the delayed output from the unit time delay circuit 302 and the delayed output from a lower-stage unit time delay circuit 307 (to be described later). The second feed-forward circuit comprises a coefficient multiplier 304 that multiplies the input signal $x_n$ by a filter coefficient $a_1$; a unit time delay circuit 305 that delays the result of the multiplication by one clock pulse; and an adder 306 that adds the delayed output from the unit time delay circuit 305 and the delayed output from a lower-stage unit time delay circuit 310 (to be described later). The third feed-forward circuit comprises a coefficient multiplier 308 that multiplies the input signal $x_n$ by a filter coefficient $a_2$; a unit time delay circuit 309 that delays the result of the multiplication by one clock pulse; and an adder 310 that adds the delayed output from the unit time delay circuit 309 and the delayed output from a lower-stage unit time delay circuit (not shown). The M-th feed-forward circuit comprises a coefficient multiplier 312 that multiplies the input signal $x_n$ by a filter coefficient $a_{M-1}$; a unit time delay circuit 313 that delays the result of the multiplication by one clock pulse; and an adder 314 that adds the delayed output from the unit time delay circuit 302 and the delayed output from a lower-stage unit time delay circuit 318 (to be described later). The (M+1)th feed-forward circuit contains a coefficient multiplier 316 that multiplies the input signal $x_n$ by a filter coefficient $a_M$; a unit time delay circuit 317 that delays the result of the multiplication by one clock pulse; and a unit time delay circuit 318 that delays by one clock pulse the delayed output from the unit time delay circuit 317.

In their feed-forward operations, the first feed-forward circuit through to the (M+1)th feed-forward circuit carry out in parallel the multiplications of the input signal $x_n$ by their respective coefficients and the delaying of the result of such multiplications.

In the feed-forward circuit 300, the unit time delay circuit 307 is located on the output side of the adder 306; the unit time delay circuit 311 on the output side of the adder 310, ..., and a unit time delay circuit 315 is located on the output side of the adder 314. The delayed outputs from these unit time delay circuits are supplied, in cascade fashion, to the adders 303, 306, ... 314 respectively located at lower stages. This circuit arrangement is intended to prevent individual multiplication time periods, unit delay time periods and addition time periods from accumulating.

The feedback loop circuit 320 comprises a unit time delay circuit 321, an adder 322 and another unit time delay circuit 323. The unit time delay circuit 321 latches and delays for a unit time the output coming from the adder 303 in the feed-forward circuit 300. The adder 322 subtracts the result of an addition by an adder 325 (to be discussed later) from the delayed output of the unit time delay circuit 321, the result of the subtraction being output as the output signal $y_n$. The unit time delay circuit 323 latches and delays for a unit time the output from the adder 322.

The feedback loop circuit 320 further comprises a first feedback loop circuit, a second feedback loop circuit, a third feedback loop circuit, ..., a N-th feedback loop circuit, and an (N+1)th feedback loop circuit. The first feedback loop circuit comprises a coefficient multiplier 324 that multiplies the delayed output from the unit time delay circuit 323 by a coefficient $b_1$; and an adder 325 that adds the output from the multiplication and the delayed output from a lower-stage unit time delay circuit 327 (to be described later). The second feedback loop circuit has a coefficient multiplier 324 that multiplies the delayed output from the unit time delay circuit 323 by a coefficient $b_2$; and an adder 327 that adds the output from the multiplication and the delayed output from a lower-stage unit time delay circuit 331 (to be described later). The third feedback loop circuit comprises a coefficient multiplier 329 that multiplies the delayed output from the unit time delay circuit 323 by a coefficient $b_3$; and an adder 330 that adds the output from the multiplication and the delayed output from a lower-stage unit time delay circuit (not shown). The N-th feedback loop circuit comprises a coefficient multiplier 332 that multiplies the delayed output from the unit time delay circuit 323 by a coefficient $b_{N-1}$; and an adder 333 that adds the output from the multiplication and the delayed output from a lower-stage unit time delay circuit 336. The (N+1)th feedback loop circuit has a coefficient multiplier 335 that multiplies the delayed output from the unit time delay circuit 323 by a coefficient $b_N$; and a unit time delay circuit 336 that delays the output from the multiplication by a unit time period.

In addition, the feedback loop circuit 320 has a unit time delay circuit 328 located on the output side of the adder 327, the circuit 328 latching and delaying for a unit time the result of the addition by the adder 327, the delayed output being sent to the adder 325. A unit time delay circuit 331 is located on the output side of the lower-stage adder 330. The delayed output from the unit time delay circuit 331 is fed to the upstream adder 327. Likewise, the output from the unit time delay circuit 336 is supplied to the adder 333.

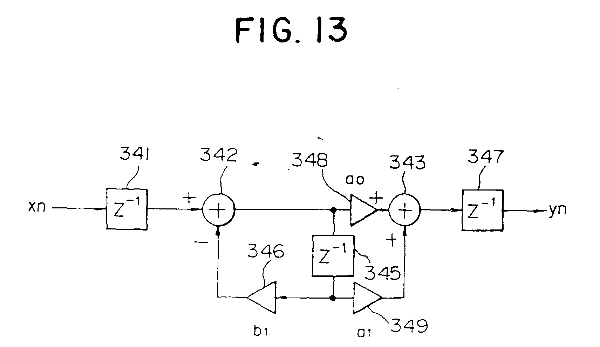

Figure 13 illustrates the construction of a simplified version of the direct cyclic digital filter in Figure 12, the filter of Figure 13 being constructed by assuming that M = N = 1.

The digital filter of Figure 13 comprises a unit time delay circuit 341 that delays the input signal $x_n$ by a unit time; an adder 342 that subtracts from the delayed output of the unit time delay circuit 341 the output from the multiplication by a coefficient multiplier 346 (to be described later); a unit time delay circuit 345 that delays for a unit time the result of the addition by the adder 342; a coefficient multiplier 346 that multiplies the delayed output from the unit time delay circuit 345 by the coefficient $b_1$; a coefficient multiplier 348 that multiplies by the coefficient $a_0$ the result of the addition by the adder 342; an adder 343 that adds the result of the multiplication by the coefficient multiplier 348 and the result of the multiplication by a coefficient multiplier 349 (to be described later); a coefficient multiplier 349 that multiplies the delayed output from the unit time delay circuit 345 by the coefficient $a_1$; and a unit time delay circuit 347 that delays for a unit time the result of the addition by the adder 343, the delayed output being output as the output signal $y_n$. These components of the digital filter in Figure 13 are interconnected as illustrated.

Practical circuits for the parallel cyclic digital filter and cascade cyclic digital filter are similarly constructed but are not shown.

A brief description will now be given of the operation time (i.e., delay time) of the direct cyclic digital filter by use of the latter's simplified form in Figure 13. As with the setup of Figure 12, assume that T1 is the time required by the adder 342 for addition and subtraction and that T2 is the time required by the coefficient multiplier 346 for coefficient multiplication. In that case, the delay time TD in the feedback loop is given as

$$TD = 2 \times T1 + T2$$

This delay time TD determines the maximum operating frequency of the cyclic digital filter.

For example, suppose that the cyclic digital filter is utilized in the empnasis or de-emphasis circuit of a high definition video tape recorder (VTR) and that the clock frequency is 44.55 MHz. Here, the delay time of the unit time delay circuit 345 equals the clock time, while the delay time TD exceeds the delay time of the unit time delay circuit 345. For this reason, a direct cyclic digital filter as shown in Figure 12 or Figure 13 cannot be employed in applications where such high frequencies are involved. The same problem persists with both the parallel cyclic digital filter and the cascade cyclic digital filter.

The invention is defined by the appended claims.

This invention provides in one aspect a cyclic digital filter comprising: a plurality of feedback loops connected in parallel, each of said plurality of feedback loops including: an adder for receiving a respective input signal and subtracting a respective delayed feedback signal from said respective input signal to form a respective subtraction result, a first unit time delay circuit connected to said adder for delaying said subtraction result and for outputting said delayed subtraction result as a respective output signal of the feedback loop, a coefficient multiplier connected to said first unit time delay circuit for multiplying said delayed subtraction result by a respective predetermined coefficient to form a respective feedback signal, and a second unit time delay circuit for delaying said respective feedback signal formed by said coefficient multiplier to provide said respective delayed feedback signal to said adder; and means for adding the respective output signals of said plurality of feedback loops; the arrangement being such that all successive arithmetic circuits of the filter are separated by unit time delays.

This invention provides in another aspect a cyclic digital filter comprising: a first adder for receiving an input signal and subtracting a feedback signal from said input signal to form a subtraction result; a first unit time delay circuit connected to said first adder for delaying said subtraction result and for outputting said delayed subtraction result; and a plurality of feedback stages connected in parallel and in cascade and each including; a coefficient multiplier connected to said first unit time delay circuit for multiplying said delayed subtraction result by a respective predetermined coefficient to form a respective multiplication result, a stage-first unit time delay circuit for delaying said respective multiplication result and for outputting a respective delayed multiplication result, a stage adder for adding said respective delayed multiplication result to a respective stage output signal provided by a next-lower feedback stage to form a respective addition result, and a stage-second unit time delay circuit for delaying said respective addition result and for providing said delayed respective addition result as a respective stage output signal; wherein said first adder receives as said feedback signal the respective stage output signal provided by an uppermost stage of said plurality of feedback stages; the arrangement being such that all successive arithmetic circuits of the filter are separated by unit time delays.

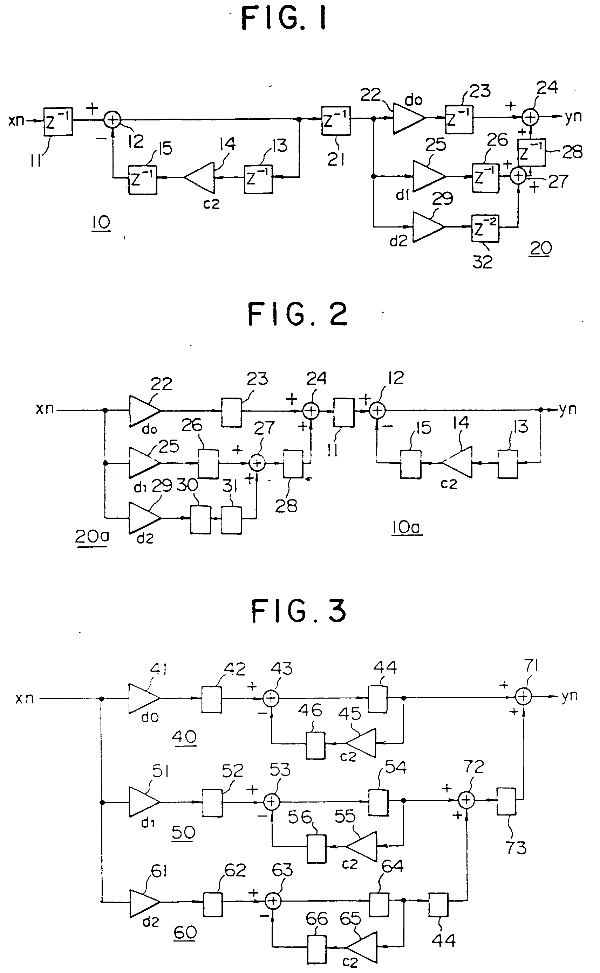

Figures 1 and 2 of the accompanying drawings show a cyclic digital filter that may be used for high frequency signal processing, and which has a feedback loop circuit comprising at least a first unit time delay circuit for delaying an input signal by a unit time, a coefficient multiplier for multiplying the output from the unit time delay circuit by a predetermined coefficient, and an adder; the adder subtracting from the input signal the result from the multiplication by the coefficient multiplier; wherein the coefficient of the coefficient multiplier is adjusted to maintain the characteristics of the cyclic digital filter in the presence of a second unit time delay circuit interposed between the coefficient multiplier and the adder.

The transfer function H(z) for the cyclic digital filter is given in the form of Equation (1). For the sake of brevity, the transfer function H(z) is expressed by Equation (4) when N = 1:

$$H(z) = \frac{a_0 + a_1 \, z^{-1}}{1 + b_1 \, z^{-1}} \tag{4}$$

Multiplying the numerator and the denominator of Equation (4) by $(1 - b_1 Z^{-1})$ provides Equation (5):

$$H(z) = \frac{(a_0 + a_1 \, z^{-1})(1 - b_1 \, z^{-1})}{(1 + b_1 \, z^{-1})(1 - b_1 \, z^{-1})}$$

$$\frac{d_0 + d_1 \, z^{-1} + d_2 \, z^{-2}}{1 + c_2 \, z^{-2}} \tag{5}$$

where

$d_0 = a_0$
$d_1 = a_1 - a_0 \, b_1$
$d_2 = -a_1 \, b_1$
$c_2 = -b_1^2$

As shown above, expressing the transfer function H(z) as $z^{-2}H(z)$ does not affect the characteristics of the cyclic digital filter; only the delay time is altered. This means that adding a second unit time delay circuit affords the delay time required by the adder and coefficient multiplier for their operation. Those changes in the filter characteristics which would ordinarily result from the addition of the second unit time delay circuit are avoided by adjusting the coefficient of the coefficient multiplier. Where, in accordance with illustrative embodiments of the invention, a plurality of feedback loops exist, each loop is furnished with a second unit time delay circuit and a coefficient multiplier whose coefficient is suitable adjusted.

The above alteration of the circuit arrangement applies not only to the direct cyclic digital filter but also to the parallel cyclic digital filter and the cascade cyclic digital filter.

The invention will now be described by way of example with reference to the accompanying drawings, throughout which like parts are referred to by like references, and in which:

Figure 1 is a circuit diagram of a direct cyclic digital filter;
Figure 2 is a circuit diagram of another direct cyclic digital filter;
Figure 3 is a circuit diagram of a parallel direct cyclic digital filter forming an embodiment of the invention;
Figure 4 is a circuit diagram of another direct cyclic digital filter;
Figure 5 is a circuit diagram of another direct cyclic digital filter which is an improved version of the embodiment of Figure 4 and which forms an embodiment of the invention;
Figure 6 is a circuit diagram of a parallel cyclic digital filter forming an embodiment of the invention;
Figure 7 is a circuit diagram of a cascade cyclic digital filter forming an embodiment of the invention;
Figure 8 is a circuit diagram showing the theoretical structure of direct cyclic digital filter;
Figure 9 is a circuit diagram depicting the theoretical structure of another direct cyclic digital filter;
Figure 10 is a circuit diagram illustrating the theoretical structure of a parallel cyclic digital filter;

Figure 11 is a circuit diagram describing the theoretical structure uf a cascade cyclic digital filter;

Figure 12 is a circuit diagram showing the practical structure of a direct cyclic digital filter; and

Figure 13 is a circuit diagram depicting the practical structure of a simplified circuit example derived from the direct cyclic digital filter of Figure 12.

Referring now to Figure 1, a circuit diagram of a direct cyclic digital filter is shown in which $M = N = 1$. This circuit construction is comparable to that of Figure 13 described above.

The direct cyclic digital filter of Figure 1 comprises a feedback loop circuit 10 and a feed-forward circuit 20 connected in series.

The feedback loop circuit 10 comprises a unit time delay circuit 11 that latches and delays the input signal $x_n$ for a unit time; an adder 12 that subtracts the delayed output of a unit time delay circuit 15 (to be described later) from the one-clock-pulse-delayed output of the unit time delay circuit 11; a unit time delay circuit 13 that latches and delays for a unit time the result of the addition by the adder 12; a coefficient multiplier 14 that multiplies the delayed output from the unit time delay circuit 13 by a coefficient $c_2$; and a unit time delay circuit 15 that latches and delays for a unit time the result of the multiplication by the coefficient multiplier 14. In operation, the delayed output of the unit time delay circuit 15 is fed to the adder 12 for subtraction thereby from the delayed output of the unit time delay circuit 11. That is, the adder 12, unit time delay circuit 13, coefficient multiplier 14 and unit time delay circuit 15 constitute a negative feedback loop circuit.

The feed-forward circuit 20 has a unit time delay circuit 21 that latches and delays the output signal from the feedback loop circuit 10 for a unit time.

Furthermore, the feed-forward circuit 20 has a first, a second and a third feed-forward circuit. The first feed-forward circuit comprises a coefficient multiplier 22 that multiplies by a coefficient $d_0$ the delayed output from the unit time delay circuit 21; a unit time delay circuit 23 which is connected in series to the coefficient multiplier 22 and which latches and delays the result of the multiplication thereby for a unit time; and an adder 24 which is located on the output side of the unit time delay circuit 23 and which adds the delayed result therefrom and the delayed output from a lower-stage unit time delay circuit 28 (to be described later). The second feed-forward circuit contains a coefficient multiplier 25 that multiplies by a coefficient $d_1$ the delayed output from the unit time delay circuit 21; a unit time delay circuit 26 which is connected in series to the coefficient multiplier 25 and which latches and delays the result of the multiplication thereby for a unit time; and an adder 27 which is located on the output side of the unit time delay circuit 26 and which adds the delayed output therefrom and the delayed output from a lower-stage two-unit time delay circuit 32 (to be described later). The third feed-forward circuit includes a coefficient multiplier 29 that multiplies by a coefficient $d_2$ the delayed output from the unit time delay circuit 21, and a two-unit time delay circuit 32 which is connected in series to the coefficient multiplier 29 and which latches and delays the result of the multiplication thereby for two unit time periods.

In the first to third feed-forward circuits arranged substantially in parallel within the feed-forward circuit 20, the delayed output from the unit time delay circuit 21 is multiplied by coefficients, latched for unit time periods, and added concurrently and in parallel.

The two-unit time delay circuit 32 latches and delays data by two clock pulses, i.e., for two unit time periods. This is a circuit equivalent to an arrangement having two ordinary unit time delay circuits connected in series. Naturally the two-unit time delay circuit 32 may be replaced with two single-unit-time delay circuits connected in series. (In the present description, the term "unit time delay circuit" refers to a single-unit-time delay circuit unless otherwise noted).

In the feed-forward circuit 20, the first to third feed-forward circuits are connected in cascade fashion. That is, the adder 24 is fed with the output from the lower-stage unit time delay circuit 28, and the lower-stage adder 27 receives the output from the two-unit time delay circuit 32.

As described, the adder 27 adds the output from the unit time delay circuit 26 and the output from the two unit time delay circuit 32. The result of the addition by the adder 27 is supplied to the adder 24 via the unit time delay circuit 28. The adder 24 adds the output from the unit time delay circuit 28 and the output from the unit time delay circuit 23, thereby generating an output signal $y_n$.

Comparing the circuit construction of Figure 1 with that of Figure 13 reveals that in the feedback loop of Figure 1, a unit time delay circuit 15 is additionally interposed between the filter coefficient multiplier 14 and the adder 12. Unit time delay circuits 11 and 13 in Figure 1 correspond respectively to unit time delay circuits 341 and 345 in Figure 13. The unit time delay circuit 21 in Figure 1 corresponds to the unit time delay circuit 347 in Figure 13. The circuit construction comparable to the feed-forward circuit 20 of Figure 1 is not shown in Figure 13.

The transfer function $H(z)$ for the cyclic digital filter of Figure 1 is expressed by Equation (5). The filter coefficient of the coefficient multiplier 14 in Figure 1 is made to differ from the coefficient of the arrangement shown in Figure 13 so as to prevent those changes in filter characteristics that would ordinarily result from the addition of the unit time delay circuit 15. Accordingly the filter coefficient of the coefficient multiplier 22 in the feed-forward circuit 20 is readjusted.

In the direct cyclic digital filter of Figure 1, adding the second unit time delay circuit 15 to the feedback loop circuit 10 doubles the unit delay time of the latter. The additional unit-time delay period allows extra time for operation of the adder 12 or coefficient multiplier 14. This means that filtering is carried out without recourse to increasing the operation speeds of the circuit components making up the cyclic digital filter. Thus the filter characteristics remain unchanged.

In Figure 1, the unit time delay circuits 11 and 21 function as latch circuits. The latch circuits are provided here to latch data for transition from one operation to another. However, these latch circuits are not essential to the operation of the present embodiment and are omitted for space reasons from some of the circuit construction illustrations that follow.

Figure 2 is a circuit diagram of another direct cyclic digital filter implemented when M = N = 1 as a variation of the embodiment in Figure 1.

The cyclic digital filter of Figure 2 comprises a feed-forward circuit 20a and a feedback loop circuit 10a connected in series.

The feed-forward circuit 20a is similar in structure to the feed-forward circuit 20 of Figure 1, except that the unit time delay circuit 21 in Figure 1 is omitted from the feed-forward circuit 20a of Figure 2. The input signal $x_n$ is input directly to the coefficient multipliers 22, 25 and 29 for multiplication by the coefficients thereof. The numerals 22 to 29 designate the same circuit components in both Figures 1 and 2. The two-unit time delay circuit 32 in Figure 1 is implemented in Figure 2 as two separate unit time delay circuits 30 and 31 connected in series.

In the feed-forward circuit 20a, the first to third feed-forward circuits multiply the input signal $x_n$ by their respective coefficients, latch and delay the results of the multiplications for the respective unit time periods, and add the delayed results concurrently and in parallel.

The feedback loop circuit 10a of Figure 2 is the same in structure as the feedback loop circuit 10 of Figure 1, except that the circuit 10a performs negative feedback filtering on the result of the operation by the feed-forward circuit 20a. The result of the filtering is output as the output signal $y_n$. In Figures 1 and 2, like reference numerals designate like or corresponding parts.

Comparing the circuit construction of Figure 2 with that of Figure 1 reveals that the feed-forward circuits 20 and 20a in the two figures have switched their places crosswise, and so have the feedback loops 10 and 10a. The symmetrically reversed circuit positions have no effect on circuit performance. That is, the circuit construction of Figure 1 may be symmetrically reversed as shown in Figure 2 with no adverse effects; likewise the circuit construction of Figure 2 may be reversed symmetrically as depicted in Figure 1.

In the cyclic digital filter of Figure 2, the feed-forward circuit 20a comprises three series circuits (three combinations of parts: 22 with 23, 25 with 26, 29 with 30) connected in parallel, each containing a coefficient multiplier (22, 25 or 29) and a unit time delay circuit. The coefficients ($d_o$, $d_1$ and $d_2$) of these coefficient multipliers correspond to those given by Equation (5). The feedback loop circuits in Figures 1 and 2 are the same in circuit structure.

As described, the two-unit time delay circuit 32 in the feed-forward circuit 20 of Figure 1 is comparable in function to the two unit time delay circuits 30 and 31 in the feed-forward circuit 20a of Figure 2. Given these features, the circuit of Figure 1 and that of Figure 2 are substantially the same.

Figure 3 is a circuit diagram of a parallel cyclic digital filter implemented as another embodiment of the invention on the assumption that M = N = 1.

The parallel cyclic digital filter of Figure 3 comprises a first, a second and a third cyclic digital filter circuit 40, 50 and 60 connected substantially in parallel.

The first cyclic digital filter circuit 40 contains a coefficient multiplier 41 that multiplies the input signal $x_n$ by a coefficient $d_0$; a unit time delay circuit 42 that latches and delays for a unit time the result of the multiplication by the coefficient multiplier 41; an adder 43 that subtracts from the delayed output of the unit time delay circuit 42 the delayed output of a unit time delay circuit 46 (to be described later); a unit time delay circuit 44 that latches and delays for a unit time the result of the addition by the adder 43; a coefficient multiplier 45 that multiplies the delayed output from the unit time delay circuit 44 by a coefficient c2; and the unit time delay circuit 46 that latches and delays for a unit time the result of the multiplication by the coefficient multiplier 45. The adder 43, unit time delay circuit 44, coefficient multiplier 45 and unit time delay circuit 46 constitute a negative feedback loop circuit.

The circuit construction of the first cyclic digital filter circuit 40 is comparable to that in Figure 2 which comprises the coefficient multiplier 22, unit time delay circuit 23, adder 24, adder 12, unit time delay circuit 13, coefficient multiplier 14 and unit time delay circuit 15 in the upper stage.

The second cyclic digital filter circuit 50 and the third cyclic digital filter circuit 60 are each similar in construction to the first cyclic digital filter circuit 40. The parts numbered 51 to 56 in the second cyclic digital filter circuit 50 and the parts numbered 61 to 66 in the third cyclic digital filter circuit 60 are respectively similar in function to those numbered 41 to 46 in the first cyclic digital filter circuit 40. One difference is that the coefficients of the coefficient multipliers 51 and 61 are $d_1$ and $d_2$, respectively, compared with $d_0$ for the coefficient multiplier 41. Another difference is that the coefficients of the coefficient multipliers 55 and 65 are $c_1$ and $c_2$, respectively, compared with $c_0$ for the coefficient multiplier 45.

The first to third cyclic digital filter circuits 40, 50 and 60 simultaneously multiply the input signal $x_n$ by the respective coefficients thereof, and latch and delay the results of the multiplications for the respective unit times for negative feedback filtering.

The parallel processed results are added consecutively by adders 72 and 71. That is, the output of the third cyclic digital filter 60 is fed to an upper-stage adder 72 via a unit time delay circuit 74. The adder 72 adds the output of the third cyclic digital filter circuit 60 and the delayed output of the unit time delay circuit 54 in the second cyclic digital filter circuit 50. The result of the addition by the adder 72 is latched by a unit time delay circuit 73 for a unit time before being sent to an upper-stage adder 71. The adder 71 adds the output of the unit time delay circuit 73 and the latched and delayed output from the unit time delay circuit 74 in the first cyclic digital filter circuit 40, thereby generating the output signal $y_n$.

The transfer function H(z) of the parallel cyclic digital filter in Figure 3 is expressed by Equation (5) above.

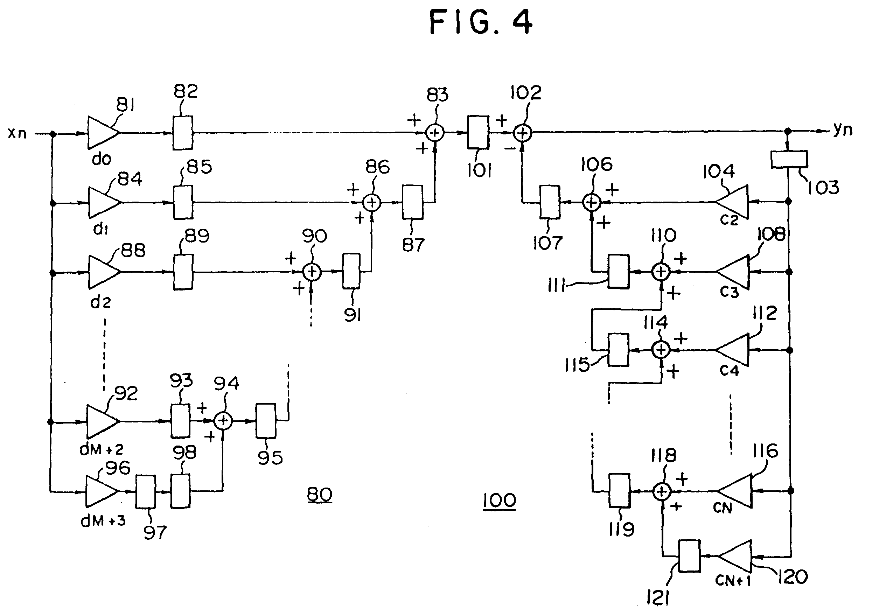

Figure 4 is a circuit diagram of another direct cyclic digital filter related to the structure as shown in Figure 12. The cyclic digital filter of Figure 4 comprises a feed-forward circuit 80 to which the input signal $x_n$ is supplied, and a feedback loop circuit 100 which is connected in series to the feed-forward circuit 80 and which outputs the output signal $y_n$.

The feed-forward circuit 80 has a first feed-forward circuit, a second feed-forward circuit, a third feed-forward circuit, ..., an (M+2+1 = M+3)th feed-forward circuit, and an (M+3+1 = M+4)th feed-forward circuit. The first feed-forward circuit contains a coefficient multiplier 81 that multiplies the input signal $x_n$ by the coefficient $d_0$; a unit time delay circuit 82 that latches and delays for a unit time the result of the multiplication by the coefficient multiplier 81; and an adder 83 that adds the delayed output from the unit time delay circuit 82 and the delayed output from a lower-stage unit time delay circuit 87. The second feed-forward circuit comprises a coefficient multiplier 84 that multiplies the input signal $x_n$ by the coefficient $d_1$; a unit time delay circuit 85 that latches and delays for a unit time the result of the multiplication by the coefficient multiplier 84; and an adder 86 that adds the delayed output from the unit time delay circuit 85 and the delayed output from a lower-stage unit time delay circuit 91. The third feed-forward circuit comprises a coefficient multiplier 88 that multiplies the input signal $x_n$ by the coefficient $d_2$; a unit time delay circuit 89 that latches and delays for a unit time the result of the multiplication by the coefficient multiplier 88; and an adder 90 that adds the delayed output from the unit time delay circuit 89 and the delayed output from a lower-stage unit time delay circuit, not shown. The (M+2+1 = M+3)th feed-forward circuit comprises a coefficient multiplier 92 that multiplies the input signal $x_n$ by a coefficient $d_{M+2}$; a unit time delay circuit 93 that latches and delays for a unit time the result of the multiplication by the coefficient multiplier 92; and an adder 94 that adds the delayed output from the unit time delay circuit 93 and the delayed output from a lower-stage unit time delay circuit 98. The (M+3+1 = M+4)th feed-forward circuit comprises a coefficient multiplier 96 that multiplies the input signal $x_n$ by a coefficient $d_{M+3}$; a unit time delay circuit 97 that latches and delays for a unit time the result of the multiplication by the coefficient multiplier 96; and the unit time delay circuit 98 that latches and delays for a unit time the delayed output from the unit time delay circuit 97.

In the feed-forward circuit 80, the delayed output from a lower-stage unit time delay circuit (e.g. the circuit 87) is fed to a higher stage adder (e.g. the adder 83). The adder adds the delayed output it receives and the one-clock-pulse-delayed result from the unit time delay circuit (e.g. the circuit 82 in the case of the adder 83) at the same stage as the adder.

The feedback loop circuit 100 has a unit time delay circuit 101, an adder 102 and another unit time delay circuit 103. The unit time delay circuit 101 latches and delays for a unit time the result of the operation by the feed-forward circuit 80. The adder 102 subtracts from the latched and delayed output of the unit time delay circuit 101 the delayed output of a unit time delay circuit 107, to be described later, thereby generating the output signal $y_n$. The unit time delay circuit 103 latches and delays the output signal $y_n$ for a unit time.

Furthermore, the feedback loop 100 includes a plurality of feedback loop circuits that are connected in parallel and in cascade fashion.

A first feedback loop circuit of the feedback loop circuit 100 comprises a coefficient multiplier 104 that multiplies by the coefficient $c_2$ the delayed output signal $y_n$ coming from the unit time delay circuit 103; an adder 106 that adds the result of the multiplication by the coefficient multiplier 104 and the delayed output from a unit time delay circuit 111 (to be described later); and a unit time delay circuit 107 that supplies the upper-stage adder 102 with the result of the addition by the adder 106 as a subtraction signal.

A second feedback loop circuit of the feedback loop circuit 100 comprises a coefficient multiplier 108 that multiplies by a coefficient $c_3$ the delayed output signal $y_n$ from the unit time delay circuit 103; an adder 110 that adds the result of the multiplication by the coefficient multiplier 108 and the delayed result from a unit time delay circuit 115 (to be described later); and a unit time delay circuit 111 that supplies the upper-stage adder 106 with the result of the addition by the adder 110 as an addition signal.

A third feedback loop circuit of the feedback loop circuit 100 comprises a coefficient multiplier 112 that multiplies by a coefficient $c_4$ the delayed output signal $y_n$ from the unit time delay circuit 103; an adder 114 that adds the result of the multiplication by the coefficient multiplier 112 and the delayed output from a lower-stage unit time delay circuit (not shown); and a unit time delay circuit 115 that supplies the upper-stage adder 110 with the result of the addition by the adder 114 as an addition signal.

Further feedback loop circuits are likewise arranged in parallel within the feedback loop circuits 100. These circuits include an (N-1)th and an N-th feedback loop circuit connected in parallel.

The (N-1)th feedback loop circuit of the feedback loop circuit 100 comprises a coefficient multiplier 116 that multiplies by a coefficient $c_N$ the delayed output signal $y_n$ from the unit time delay circuit 103; an adder 118 that adds the result of the multiplication by the coefficient multiplier 116 and the delayed output from a unit time delay circuit 121 (to be described later); and a unit time delay circuit 119 that supplies an upper-stage adder (not shown) with the result of the addition by the adder 118 as an addition signal.

The N-th feedback loop circuit of the feedback loop circuit 100 has a coefficient multiplier 120 that multiplies by a coefficient $c_{N+1}$ the delayed output signal $y_n$ from the unit time delay circuit 103; and a unit time delay circuit 121 that supplies the upper-stage adder 118 with the result of the multiplication by the coefficient multiplier 120 as an addition signal.

Put another way, the feedback loop circuit 100 has the unit time delay circuit 119 that latches the result of the addition by the adder 118 before sending it to an upper-stage adder; ...; the unit time delay circuit 115 that latches the result of the addition by the adder 114 before sending it to the upper-stage adder 110; the unit time delay circuit 111 that latches the result of the addition by the adder 110 before sending it to the upper-stage adder 106; and the unit time delay circuit 107 that latches the result of the addition by the adder 106 before sending it to the upper-stage adder 102. The adder 102 outputs the output signal $y_n$.

In the above-described direct cyclic digital filter it is assumed that N is at least 2. The transfer function H(z) of this filter is expressed by Equation (6):

$$H(z) = \frac{\sum_{\mu=0}^{M} a_\mu \cdot z^{-\mu}}{1 + \sum_{\nu=2}^{N} b_\nu \cdot z^{-\nu}} \qquad (N \geq M)$$

$$= \frac{\sum_{\mu=0}^{M} a_\mu \cdot z^{-\mu}}{1 + b_1 \cdot z^{-1} + \sum_{\nu=2}^{N} b_\nu \cdot z^{-\nu}} \cdot \frac{(1 - b_1 z^{-1})}{(1 - b_1 z^{-1})}$$

$$= \frac{\sum_{\mu=0}^{M+1} d_\mu \cdot z^{-\mu}}{1 + \sum_{\nu=2}^{N+1} c_\nu \cdot z^{-\nu}} \qquad (6)$$

where:

$$d_\mu = \begin{cases} a_0 & (\mu = 0) \\ a_\mu - b_1 \cdot a_{\mu-1} & (1 \leq \mu \leq M) \\ -b_1 \cdot a_M & (\mu = M+1) \end{cases}$$

$$c_\nu = \begin{cases} -b_1^2 + b_2 & (\nu = 2) \\ b_\nu - b_1 \cdot b_{\nu-1} & (3 \leq \nu \leq N) \\ -b_1 \cdot b_N & (\nu = N+1) \end{cases}$$

The coefficients $d_\mu$ of the coefficient multiplier in the feed-forward circuit of Figure 4 and the coefficients $d_\nu$ of the coefficient multiplier in the feedback loop of the same figure are determined from equation (6).

A comparison of the circuit construction of the cyclic digital filter in Figure 4 with that of the filter in Figure 12 shows that the feedback loop circuit 100 of the cyclic digital filter in Figure 4 has the additional unit time delay circuit 107 interposed between the adders 106 and 102, the latter functioning as an adder-subtracter. This means that the cyclic digital filter of Figure 4 provides the adders 106 and 102 with an additional unit delay time afforded by the unit time delay circuit 107.

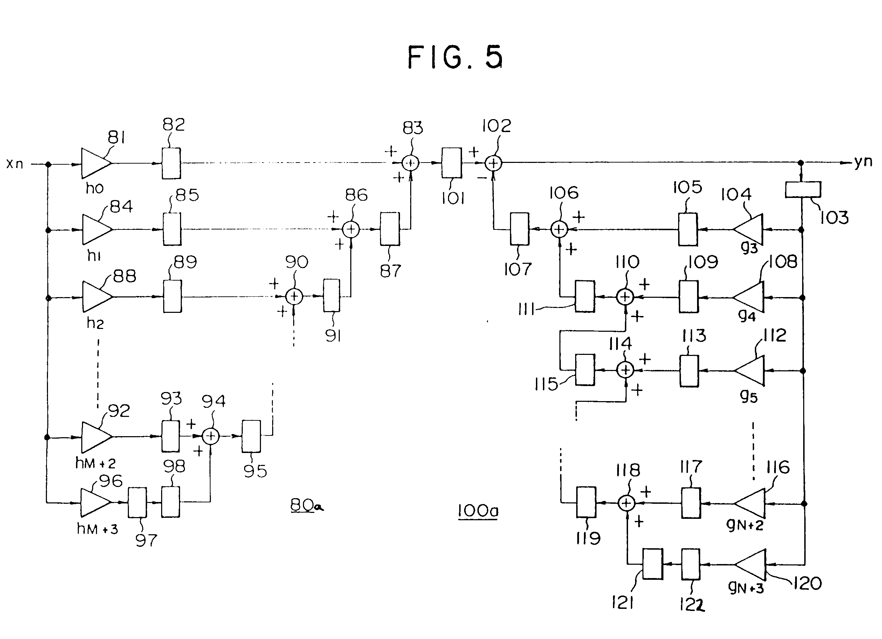

Figure 5 is a circuit diagram of a cyclic digital filter improved over the circuit construction shown in Figure 4. The filter of Figure 5 is similar in construction to the cyclic digital filter of Figure 4, the former comprising a feed-forward circuit 80a and a feedback loop circuit 100a.

The feed-forward circuit 80a is substantially the same in construction as the feed-forward circuit 80 in Figure 4. The difference is that the coefficient multipliers 81, 84, 88, ..., 92 and 96 have coefficients $d_0$, $d_1$, $d_2$, ..., $d_{M+2}$ and $d_{M+3}$ respectively in the construction of Figure 4, compared with the corresponding coefficients $h_0$, $h_1$, $h_2$, ..., $h_{M+2}$ and $h_{M+3}$ in the construction of Figure 5.

The feedback loop circuit 100a is also substantially similar in construction as the feedback loop circuit 100 in Figure 4. The difference is that the coefficient multipliers 104, 108, 112, ..., 116 and 120 have coefficients $c_2$, $c_3$, $c_4$, ..., $c_N$ and $c_{N+1}$ respectively in the construction of Figure 4, compared with the corresponding coefficients $g_3$, $g_4$, $g_5$, ..., $g_{N+2}$ and $g_{N+3}$ in the construction of Figure 5.

The operation of the circuit in Figure 5 is represented by Equation (7) which can be obtained by modifying Equation (6):

$$H(z) = \frac{\sum_{\mu=0}^{M+1} d_\mu \cdot z^{-\mu}}{1 + c_2 \cdot z^{-2} + \sum_{\nu=3}^{N+1} c_\nu \cdot z^{-\nu}} \cdot \frac{1 - c_2 \cdot z^{-2}}{1 - c_2 \cdot z^{-2}}$$

$$= \frac{\sum_{\mu=0}^{M+3} h_\mu \cdot z^{-\mu}}{1 + \sum_{\nu=3}^{N+3} g_\nu \cdot z^{-\nu}} \qquad (7)$$

where:

$$h_\mu = \begin{cases} d_\mu & (0 \leq \mu \leq 1) \\ d_\mu - c_2 \cdot d_{\mu-2} & (2 \leq \mu \leq M+1) \\ - c_2 \cdot d_{\mu-2} & (M+2 \leq \mu \leq M+3) \end{cases}$$

$$g_\nu = \begin{cases} c_3 & (\nu = 3) \\ -c_2^2 + c_4 & (\nu = 4) \\ c_\nu - c_2 \cdot c_{\nu-2} & (5 \leq \nu \leq N+1) \\ - c_2 \cdot c_{\nu-2} & (N+2 \leq \nu \leq N+3) \end{cases}$$

The coefficients $h_\mu$ ($\mu$ ranges from 0 to M+3) of the coefficient multipliers in the feed-forward circuit 80a and the coefficients $g_\nu$ ($\nu$ ranges from 3 to N+3) of the coefficient multipliers in the feedback loop 100a are determined from equation (7).

In the circuit construction of Figure 5, a plurality of series circuits constitute the feedback loop 100a. Each series circuit contains a second unit time delay circuit (105, 109, 113, 117, 122) between the respective coefficient multiplier and adder. For example, a second unit time delay circuit 105 is interposed between the coefficient multiplier 104 and the adder 106. Thus the coefficient multiplier 104 is provided for its operation with the delay time from the unit time delay circuit 105.

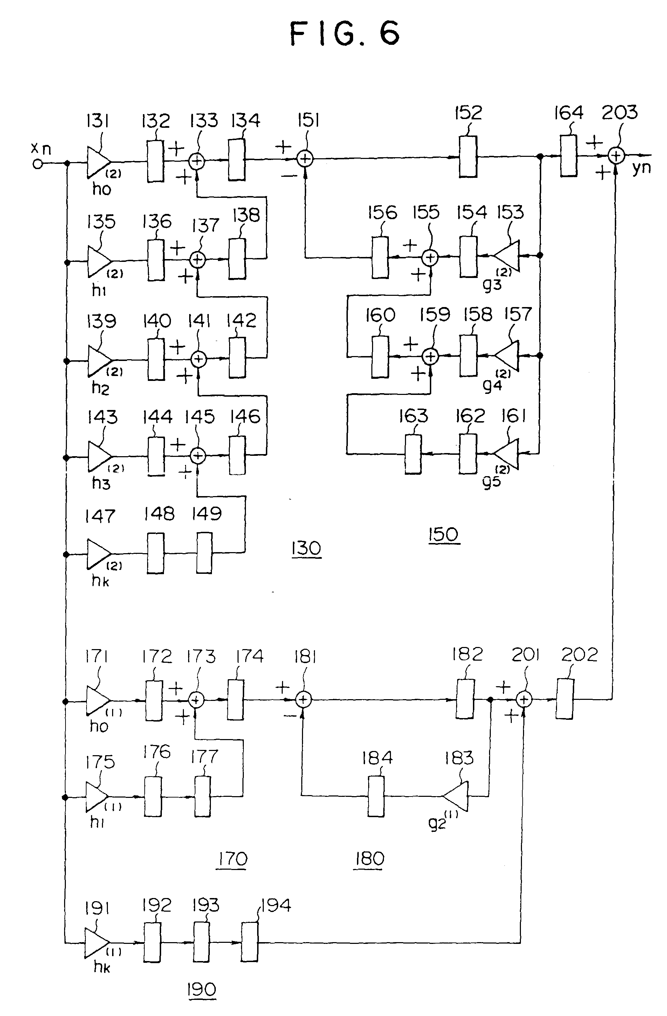

Figure 6 is a circuit diagram of a parallel cyclic digital filter. The theoretical structure of this filter is illustrated in Figure 10. The parallel cyclic digital filter of Figure 6 comprises a first feed-forward circuit 130, a first feedback loop circuit 150 corresponding to the first feed-forward circuit 130, a second feed-forward circuit 170, a second feedback loop circuit 180 corresponding to the second feed-forward circuit 170, and a third feed-forward circuit 190.

The first feed-forward circuit 130 has five (a first to a fifth) feed-forward circuits arranged substantially in parallel and connected in cascade fashion.

The first of these feed-forward circuits comprises a coefficient multiplier 131 having a coefficient $h_0^{(2)}$, a unit time delay circuit 132, an adder 133, and a unit time delay circuit 134. The second feed-forward circuit contains a coefficient multiplier 135 having a coefficient $h_1^{(2)}$, a unit time delay circuit 136, an adder 137, and a unit time delay circuit 138. The third feed-forward circuit includes a coefficient multiplier 139 having a coefficient $h_2^{(2)}$, a unit time delay circuit 140, an adder 141, and a unit time delay circuit 142. The fourth feed-forward circuit comprises a coefficient multiplier 143 having a coefficient $h_3^{(2)}$, a unit time delay circuit 144, an adder 145, and a unit time delay circuit 146. The fifth feed-forward circuit contains a coefficient multiplier 147 having a coefficient $h_k^{(2)}$, a unit time delay circuit 148, and an adder 149.

The adder 133 is supplied with the delayed output from the lower-stage unit time delay circuit 138; the adder 137 is supplied with the delayed output from the lower-stage unit time delay circuit 142; the adder 141 is supplied with the delayed output from the lower-stage unit time delay circuit 146; and the adder 145 is supplied with the delayed output from the lower-stage unit time delay circuit 149. These lower-stage unit time delay circuits are used to provide the timings of their respective upper-stage adders.

The first feedback loop circuit 150 has an adder 151 and unit time delay circuits 152 and 164. The adder 151 functions as a subtracter that subtracts the delayed output of a unit time delay circuit 156 (to be described later) from the result of the operation by the feed-forward circuit 130. The unit time delay circuit 152 latches and delays the result of the subtraction by the adder 151 for a unit time. The unit time delay circuit 164 latches and delays the result of the subtraction for another unit time.

The first feedback loop circuit 150 comprises a first, a second and a third feedback loop circuit. The first of these feedback loop circuits contains a coefficient multiplier 153 that multiplies by a coefficient $g_3^{(2)}$ the delayed output from the unit time delay circuit 152; a unit time delay circuit 154 that latches and delays the result of the multiplication by the coefficient multiplier 153; an adder 155 that adds the delayed output from the unit time delay circuit 154 and the delayed output from a lower-stage unit time delay circuit 160; and a unit time delay circuit 156 that supplies the upper-stage adder 151 with the result of the addition by the adder 155 as a subtraction signal.

The second feedback loop circuit comprises a coefficient multiplier 157 that multiplies the delayed output from the unit time delay circuit 152 by a coefficient $g_4^{(2)}$; a unit time delay circuit 158 that latches and delays for a unit time the result of the multiplication by the coefficient multiplier 157; an adder 159 that adds the delayed output from the unit time delay circuit 158 and the delayed output from a lower-stage unit time delay circuit 163 (to be described later); and a unit time delay circuit 160 that supplies the upper-stage adder 155 with the result of the addition by the adder 159 as an addition signal.

The third feedback loop circuit comprises a coefficient multiplier 161 that multiplies the delayed output from the unit time delay circuit 152 by a coefficient $g_5^{(2)}$; a unit time delay circuit 162 that latches and delays the result of the multiplication by the coefficient multiplier 161; and a unit time delay circuit 163 that latches and delays for another unit time the delayed output from the unit time delay circuit 162.

As described, besides receiving the output from the feed-forward circuit 130, the adder 151 is supplied with the output from the lower-stage unit time delay circuit 156 as a subtraction signal. The adder 155 is supplied with the output from the lower-stage unit time delay circuit 160, and the adder 159 is supplied with the output from the lower-stage unit time delay circuit 163. These lower-stage unit time delay circuits are used to provide the timings of their respective upper-stage adders.

The second feed-forward circuit 170 includes first and second feed-forward circuits parts. The first feed-forward circuit part comprises a coefficient multiplier 171 that multiplies the input signal $x_n$ by a coefficient $h_0^{(1)}$; a unit time delay circuit 172 that latches and delays the result of the multiplication by the coefficient multiplier 171; an adder 173 that adds the delayed output from the unit time delay circuit 172 and the delayed output from a lower-stage unit time delay circuit 177 (to be described later); and a unit time delay circuit 174 that latches and delays the result of the addition by the adder 173. The second feed-forward circuit part has a coefficient multiplier 175 that multiplies the input signal $x_n$ by a coefficient $h_1^{(1)}$; a unit time delay circuit 176 that latches and delays for a unit time the result of the multiplication by the coefficient multiplier 175; and a unit time delay circuit 177 that latches and delays for another unit time the delayed output from the unit time delay circuit 176.

The second feedback loop circuit 180 comprises an adder 181, a unit time delay circuit 182, a coefficient multiplier 183 and a unit time delay circuit 184. The adder 181 functions as a subtracter that subtracts the delayed output of the unit time delay circuit 184 from the result of the operation by the second feed-forward circuit 170. The unit time delay circuit 182 latches and delays for a unit time the result of the subtraction by the adder 181. The coefficient multiplier 183 multiplies by a coefficient $g_2^{(1)}$ the delayed output from the unit time delay circuit 182. The unit time delay circuit 184 latches and delays for a unit time the result of the multiplication by the coefficient multiplier 183.

The third feed-forward circuit 190 comprises a coefficient multiplier 191 having a coefficient $h_k^{(1)}$, and three unit time delay circuits 192, 193 and 194 connected in series to provide a three-clock pulse delay.

Furthermore, the cyclic digital filter of Figure 6 includes an adder 201 that adds the output from the third feed-forward circuit 190 and the output from the second feedback loop circuit 180; a unit time delay circuit 202 that latches the result of the addition by the adder 201; and an adder 203 that adds the output from the unit time delay circuit 202 and the output from the unit time delay circuit 164 of the first feedback loop circuit 150.

The coefficients of the coefficient multipliers contained in the above cyclic digital filter are listed in Table 1 below.

Table 1

$$h_0^{(0)} = a_0$$

$$h_0^{(1)} = a_{01}^{(1)}$$
$$h_1^{(1)} = - a_{01}^{(1)} \cdot b_{11}^{(1)}$$

$$g_2^{(1)} = -[b_{11}^{(1)}]^2$$

$$h_0^{(2)} = a_{01}^{(2)}$$
$$h_1^{(2)} = a_{11}^{(2)} - a_{01}^{(2)} \cdot b_{11}^{(2)}$$
$$h_2^{(2)} = - a_{11}^{(2)} \cdot b_{11}^{(2)} - a_{01}^{(2)} \cdot [b_{21}^{(2)} - (b_{11}^{(2)})^2]$$
$$h_3^{(2)} = -(a_{11}^{(2)} - a_{01}^{(2)} \cdot b_{11}^{(2)}) \times [b_{21}^{(2)} - (b_{11}^{(2)})^2]$$
$$h_4^{(2)} = - [b_{21}^{(2)} - (b_{11}^{(2)})^2] \cdot a_{11}^{(2)} \cdot b_{11}^{(2)}$$

$$g_3^{(2)} = - b_{11}^{(2)} \cdot b_{21}^{(2)}$$
$$g_4^{(2)} = - [b_{21}^{(2)} - (b_{11}^{(2)})^2]^2$$
$$g_5^{(2)} = b_{11}^{(2)} \cdot b_{21}^{(2)} \cdot [b_{21}^{(2)} - (b_{11}^{(2)})^2]$$

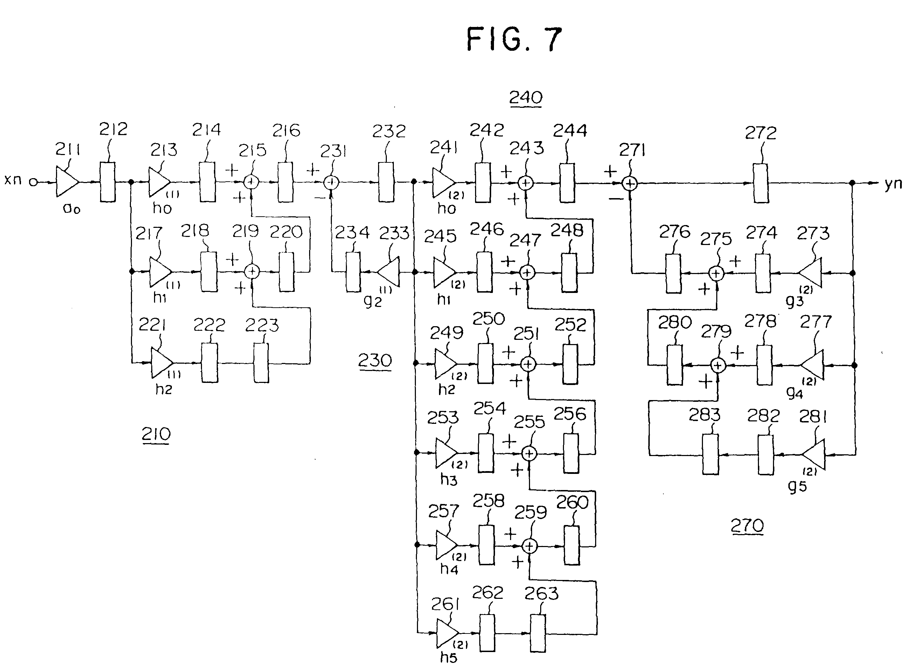

Figure 7 is a circuit diagram of a cascade cyclic digital filter. The theoretical structure of this filter is depicted in Figure 11. The cascade cyclic digital filter of Figure 7 comprises a first feed-forward circuit 210, a first feedback loop circuit 230, a second feed-forward circuit 240, and a second feedback loop circuit 270, all connection in cascade fashion.

The first feed-forward circuit 210 has a first, a second and a third feed-forward circuit connected in cascade fashion. The first feed-forward circuit comprises a coefficient multiplier 211 that multiples the input signal $x_n$ by the coefficient $a_0$; a unit time delay circuit 212; a coefficient multiplier 213 having the coefficient $h_0^{(1)}$; a unit time delay circuit 214; an adder 215; and a unit time delay circuit 216. The second feed-forward circuit comprises a coefficient multiplier 217 having the coefficient $h_1^{(1)}$, a unit time delay circuit 218, an adder 219, and a unit time delay circuit 220. The third feed-forward circuit comprises a coefficient multiplier 221 having the coefficient $h_2^{(1)}$, a unit time delay circuit 222, and another unit time delay circuit 223. The adder 215 is supplied with the output from the lower-stage unit time delay circuit 220, and the adder 219 is supplied with the output from the lower-stage unit time delay circuit 223.

The first feedback loop circuit 230 comprises an adder 231, a unit time delay circuit 232, a coefficient multiplier 233 having the coefficient $g_2^{(1)}$, and a unit time delay circuit 234.

The second feed-forward circuit 240 comprises six feed-forward circuits arranged in parallel and connected in cascade fashion. Each of these feed-forward circuits will be described below.

The first feed-forward circuit in the second feed-forward circuit 240 comprises a coefficient multiplier 241 having the coefficient $h_0^{(2)}$, a unit time delay circuit 242, an adder 243, and a unit time delay circuit 244.

The second feed-forward circuit in the second feed-forward circuit 240 comprises a coefficient multiplier 245 having the coefficient $h_1^{(2)}$, a unit time delay circuit 246, an adder 247, and a unit time delay circuit 248.

The third feed-forward circuit in the second feed-forward circuit 240 comprises a coefficient multiplier 249 having the coefficient $h_2^{(2)}$, a unit time delay circuit 250, an adder 251, and a unit time delay circuit 252.

The fourth feed-forward circuit in the second feed-forward circuit 240 comprises a coefficient multiplier 253 having the coefficient $h_3^{(2)}$, unit time delay circuit 254, an adder 255, and a unit time delay circuit 256.

The fifth feed-forward circuit in the second feed-forward circuit 240 comprises a coefficient multiplier 257 having a coefficient $h_4^{(2)}$, a unit time delay circuit 258, an adder 259, and a unit time delay circuit 260.

The sixth feed-forward circuit in the second feed-forward circuit 240 comprises a coefficient multiplier 261 having a coefficient $h_5^{(2)}$, a unit time delay circuit 262, and another unit time delay circuit 263.

In the second feed-forward circuit 240, the adder 243 is supplied with the output from the lower-stage unit time delay circuit 248; the adder 247 is supplied with the output from the lower-stage unit time delay circuit 252; the adder 251 is supplied with the output from the lower-stage unit time delay circuit 256; the adder 255 is supplied with the output from the lower-stage unit time delay circuit 260; and the adder 259 is supplied with the output from the lower-stage unit time delay circuit 263. These lower-stage unit time delay circuits are used to provide the timings of their respective upper-stage adders.

The second feedback loop circuit 270 comprises an adder 271 and a unit time delay circuit 272. The adder 271 functions as a subtracter that subtracts the delayed output of a unit time delay circuit 276 (to be described later) from the result of the operation by the second feed-forward circuit 240. The unit time delay circuit 272 latches and delays the result of the subtraction by the adder 271.

The second feedback loop circuit 270 also includes three feedback loop circuits arranged in parallel and connected in a cascade fashion. Each of these feedback loop circuits will be described below.

The first feedback loop circuit in the second feedback loop circuit 270 includes a coefficient multiplier 273 that multiplies the delayed output from the unit time delay circuit 272 by a coefficient $g_3^{(2)}$; a unit time delay circuit 274 that latches and delays the result of the multiplication by the coefficient multiplier 273; an adder 275 that adds the delayed output from the unit time delay circuit 274 and the delayed output from a unit time delay circuit 280 (to be described later); and a unit time delay circuit 276 that latches and delays the result of the addition by the adder 275.

The second feedback loop circuit in the second feedback loop circuit 270 comprises a unit time delay circuit 277 that multiplies the delayed output from the unit time delay circuit 272 by a coefficient $g_4^{(2)}$; a unit time delay circuit 278 that latches and delays the result of the multiplication by the coefficient multiplier 277; an adder 279 that adds the delayed output from the unit time delay circuit 278 and the delayed output from a unit time delay circuit 283 (to be described later); and the unit time delay circuit 280 that latches and delays the result of the addition by the adder 279.

The third feedback loop circuit in the second feedback loop circuit 270 comprises a coefficient multiplier 281 that multiplies the delayed output from the unit time delay circuit 272 by a coefficient $g_5^{(2)}$; a unit time delay circuit 282 that latches and delays the result of the multiplication by the coefficient multiplier 281; and a unit time delay circuit 2 3 that latches and delays for another unit time the delayed output from the unit time delay circuit 282.

In the second feedback loop circuit 270, the adder 271 is fed with the output from the lower-stage unit time delay circuit 276 as a subtraction signal; the adder 275 is supplied with the output from the lower-stage unit time delay circuit 280 as an additional signal; and the adder 279 is provided with the output from the lower-stage unit time delay circuit 283 as an addition signal. These lower-stage unit time delay circuits are used to provide the timings of their respective upper-stage adders.

The coefficients of the coefficient multipliers contained in this cascade cyclic digital filter are listed in Table 2 below.

Table 2

$$h_0^{(1)} = 1$$
$$h_1^{(1)} = a_{11}^{(1)} - b_{11}^{(1)}$$
$$h_2^{(1)} = - a_{11}^{(1)} \cdot b_{11}^{(1)}$$

$$g_3^{(1)} = - [b_{11}^{(1)}]^2$$

$$h_0^{(2)} = 1$$
$$h_1^{(2)} = a_{11}^{(2)} - b_{11}^{(2)}$$
$$h_2^{(2)} = (a_{21}^{(2)} - a_{11}^{(2)} \cdot b_{11}^{(2)}) - b_{21}^{(2)} - (b_{11}^{(2)})^2]$$
$$h_3^{(2)} = - a_{21}^{(2)} \cdot b_{11}^{(2)} - (a_{11}^{(2)} - b_{11}^{(2)}) \cdot [b_{21}^{(2)} - (b_{11}^{(2)})^2]$$
$$h_4^{(2)} = - (a_{21}^{(2)} - a_{11}^{(2)} \cdot b_{11}^{(2)}) \times [b_{21}^{(2)} - (b_{11}^{(2)})^2]$$
$$h_5^{(2)} = a_{21}^{(2)} \cdot b_{11}^{(2)} \cdot [b_{21}^{(2)} - (b_{11}^{(2)})^2]$$

$$g_3^{(2)} = -b_{11}^{(2)} \cdot b_{21}^{(2)}$$
$$g_4^{(2)} = -[b_{21}^{(2)} - (b_{11}^{(2)})^2]^2$$
$$g_5^{(2)} = b_{11}^{(2)} \cdot b_{21}^{(2)} \cdot [b_{21}^{(2)} - (b_{11}^{(2)})^2]$$

As described above, a second unit time delay circuit is additionally interposed between the coefficient multiplier and adder in a feedback loop circuit without causing substantial changes in the characteristics of the cyclic digital filter. Because the added unit time delay circuit ensures an additional operation time, high-speed cyclic (recursive) can be carried out with no increase in the maximum operation frequency involved. Thus the cyclic digital filter described above may illustratively be used as an emphasis circuit for high-speed digital filtering in a high definition VTR.

**Claims**

1. A cyclic digital filter comprising:
   a plurality of feedback loops (40, 50, 60) connected in parallel, each of said plurality of feedback loops including:

   an adder (43, 53, 63) for receiving a respective input signal and subtracting a respective delayed feedback signal from said respective input signal to form a respective subtraction result,
   a first unit time delay circuit (44, 54, 64) connected to said adder for delaying said subtraction result and for outputting said delayed subtraction result as a respective output signal of the feedback loop, a coefficient multiplier (45, 55, 65) connected to said first unit time delay circuit for multiplying said delayed subtraction result by a respective predetermined coefficient (Cn) to form a respective feedback signal, and
   a second unit time delay circuit (46, 56, 66) for delaying said respective feedback signal formed by said coefficient multiplier to provide said respective delayed feedback signal to said adder; and
   means (72, 71) for adding the respective output signals of said plurality of feedback loops;
   the arrangement being such that all successive arithmetic circuits of the filter are separated by unit time delays.

2. A cyclic digital filter comprising:

   a first adder (102, 151, 271) for receiving an input signal and subtracting a feedback signal from said input signal to form a subtraction result;
   a first unit time delay circuit (103, 152, 272) connected to said first adder for delaying said subtraction result and for outputting said delayed subtraction result; and
   a plurality of feedback stages connected in parallel and in cascade and each including;
   a coefficient multiplier (104, 108, 112, 116; 153, 157, 161; 273, 277, 281) connected to said first unit time delay circuit for multiplying said delayed subtraction result by a respective predetermined coefficient (gn) to form a respective multiplication result,
   a stage-first unit time delay circuit (105, 109, 113, 117; 154, 158, 162; 274, 278, 282) for delaying said respective multiplication result and for outputting a respective delayed multiplication result,
   a stage adder (106, 110, 114, 118; 155, 159; 275, 279) for adding said respective delayed multiplication result to a respective stage output signal provided by a next-lower feedback stage to form a respective addition result, and
   a stage-second unit time delay circuit (107, 111, 115, 119; 156, 160; 276, 280) for delaying said respective addition result and for providing said delayed respective addition result as a respective stage output signal;
   wherein said first adder (102, 151, 271) receives as said feedback signal the respective stage output signal provided by an uppermost stage of said plurality of feedback stages;
   the arrangement being such that all successive arithmetic circuits of the filter are separated by unit time delays.

3. A cyclic digital filter according to claim 2, further comprising a lowermost feedback stage which includes:

   a last coefficient multiplier (120, 161, 281) connected to said first time unit delay circuit (103, 152, 272) for multiplying said output signal by a respective predetermined coefficient to form a respective multiplication result;
   a lowest-stage-first unit time delay circuit (122, 162, 282) for delaying said multiplication result formed by said last coefficient multiplier and outputting a respective delayed multiplication result; and
   lowest-stage-second unit time delay circuit (121, 163, 283) for further delaying said delayed multiplication result outputted from said lowest-state-first unit time delay circuit and for providing said further delayed multiplication result as said respective stage output signal provided to the respective stage adder of a lowest stage of said plurality feedback stages.

4. A filter according to claim 2 or 3, wherein the said first adder (102) forms the output signal of the filter and the said first unit time delay (103) delays the output signal.

5. A filter according to claim 2 or 3, wherein the said first unit time delay (272) forms the output signal of the filter.

**6.** A digital filter arrangement comprising a pole section provided by a cyclic filter according to claim 2, 3, 4 or 5 and a zero section wherein the zero section comprises an input for receiving an input signal (xn) and a plurality of feed-forward stages connected in parallel and each including in cascade:

a coefficient multiplier (81, 84, 88; 96) connected to the input (xn) for multiplying the input signal by a respective coefficient (dn) to form a multiplication result,
a stage first unit-time delay (82, 85, 89, ...98) for delaying the multiplication result,
a stage adder (83, 86, 90, ...95) for adding the delayed multiplication result to the output signal of the next lower stage, to form an addition result and
a stage second unit-time delay (101, 87, 91, 95) for delaying the addition result to form the stage output signal; wherein the stage adder of the uppermost stage outputs a signal which is the summation of all the stage output signals, the arrangement being such that all successive arithmetic circuits of the filter arrangement are separated by unit time delays.

**7.** An arrangement according to claim 8 wherein the lowermost feed forward stage comprises

a coefficient multiplier (96) connected to the input (xn) for multiplying the input signal by a coefficient (dn) to form a multiplication result
first and second unit time delays (97, 98) for delaying the multiplication result, the delayed multiplication result being the stage output signal of the lowermost stage.

**8.** A digital filter arrangement comprising a pole section according to claim 1 and a zero section, wherein the filter comprises an input for receiving an input signal (xn) and a plurality of stages connected in parallell, each including in cascade : a coefficient multiplier (41 - 51, 61) connected to the input for multiplying the input signal (xn) by a respective coefficient (dn) to form a multiplication result,

a stage first unit time delay (42, 52, 62) for delaying the multiplication result,
a respective one of said feed-back loops (40, 50, 60) the said adder (43, 53, 63) of which receives the delayed multiplication result as the said respective input signal thereof, the said means (71, 72) for adding comprises in each stage, except the lowermost, a stage adder for adding the output signal of the feedback loop of that stage to a delayed output signal of the feed-back loop of the next lower stage to form an addition result the or each stage intermediate the uppermost and the lowermost having a stage second unit time delay for delaying the addition result to form the said delayed output signal, the arrangement being such that all successive arithmetic stages of the filter arrangement are separated by unit time delays.

**9.** A digital filter according to claim 8, wherein the lowermost stage comprises a coefficient multiplier (61) connected to the input for multiplying the input signal (xn) by a coefficient (dn) to form a multiplication result, a stage first unit time delay for delaying the multiplication result, a respective one of said feedback loops (60) and a stage second unit time delay for delaying the output signal of the loop to form the delayed output signal of the stage.

**Patentansprüche**

**1.** Zyklisches digitales Filter
mit einer Mehrzahl von parallel angeordneten Rückkopplungsschleifen (40, 50, 60), wobei jede aus dieser Mehrzahl von Rückkopplungsschleifen aufweist:

einen Addierer (43, 53, 63) zur Aufnahme eines Eingangssignals und zum Subtrahieren eines verzögerten Rückkopplungssignals von dem Eingangssignal, um ein Subtraktionsergebnis zu erzeugen,
eine mit dem Addierer verbundene erste Einheitszeitverzögerungsschaltung (44, 54, 64) zum Verzögern des Subtraktionsergebnisses und zur Ausgabe des verzögerten Subtraktionsergebnisses als Ausgangssignal der Rückkopplungsschleife,
einen mit der ersten Einheitszeitverzögerungsschaltung verbundenen Koeffizientenmultiplizierer (45, 55, 65) zum Multiplizieren des verzögerten Subtraktionsergebnisses mit einem vorbestimmten Koeffizienten (Cn), um ein Rückkopplungssignal zu erzeugen,
und eine zweite Einheitszeitverzögerungsschaltung (46, 56, 66) zum Verzögern des von dem Koeffizientenmultiplizierer erzeugten Rückkopplungssignals und zur Lieferung des verzögerten Rückkopplungssignals an den Addierer,

sowie mit Addiereinrictungen (72, 71) zum Addieren der einzeinen Ausgangssignale der Mehrzahl von Rückkopplungsschleifen,

wobei die Anordnung so ausgebildet ist, daß alle aufeinanderfolgenden Rechenschaltungen des Filters durch Einheitszeitverzögerungen voneinander getrennt sind.

2. Zyklisches digitales Filter,

mit einem ersten Addierer (102, 151, 271) zur Aufnahme eines Eingangssignals und zum Subtrahieren eines Rückkopplungssignals von dem Eingangssignal, um ein Subtraktionsergebnis zu erzeugen,

mit einer mit dem ersten Addierer verbundene erste Einheitszeitverzögerungsschaltung (103, 152, 272) zum Verzögern des Subtraktionsergebnisses und zur Ausgabe des verzögerten Subtraktionsergebnisses

und mit einer Mehrzahl von Rückkopplungsstufen, die parallel und in Kaskade angeordnet sind und jeweils aufweisen:

einen mit der ersten Einheitszeitverzögerungsschaltung verbundenen Koeffizientenmultiplizierer (104, 108, 112, 116; 153, 157, 161; 273, 277, 281) zum Multiplizieren des verzögerten Subtraktionsergebnisses mit einem vorbestimmten Koeffizienten (gn), um ein entsprechendes verzögerten Multiplikationsergebnis zu erzeugen,

eine erste Stufen-Einheitszeitverzögerungsschaltung (105, 109, 113, 117; 154, 158, 162; 278, 278, 282) zum Verzögern des jeweiligen Multiplikationsergebnisses und zur Ausgabe eines entsprechenden Multiplikationsergebnisses,

einen Stufen-Addierer (106, 110, 114, 118; 155, 159; 275, 279) zum Addieren des jeweiligen verzögerten Multiplikationsergebnisses zu einem von der nächstniedrigeren Rückkopplungsstufe gelieferten Stufen-Ausgangssignal und zur Erzeugung eines entsprechenden Additionsergebnisses, und

eine zweite Stufen-Einheitszeitverzögerungsschaltung (107, 111, 15, 119; 156, 160; 276, 280) zum Verzögern des jeweiligen Additionsergebnisses und zur Lieferung des verzögerten Additionsergebnisses als Stufen-Ausgangssignal,

wobei der erste Addierer (102, 151, 271) als Rückkopplungssignal das von der höchsten Stufe aus der Mehrzahl von Rückkopplungsstufen gelieferte Stufen-Ausgangssignal aufnimmt,

und wobei die Anordnung so ausgebildet ist, daß alle aufeinanderfolgenden Rechenschaltungen des Filters durch Einheitszeitverzögerungen voneinander getrennt sind.

3. Zyklisches digitales Filter nach Anspruch 2 mit einer niedrigsten Rückkopplungsstufe, die aufweist:

einen mit der ersten Einheitszeitverzögerungsschaltung (103, 152, 172) verbundenen letzten Koeffizientenmultiplizierer (120, 161, 281) zum Multiplizieren des genannten Ausgangssignals mit einem vorbestimmten Koeffizienten um ein entsprechendes Multiplikationsergebnis zu erzeugen,

eine erste Einheitszeitverzögerungsschaltung (122, 162, 282) niedrigster Stufe zum Verzögern des von dem letzten Koeffizientenmultiplizierer erzeugten Multiplikationsergebnisses und zur Ausgabe eines entsprechenden verzögerten Multiplikationsergebnisses

und eine zweite Einheitszeitverzögerungsschaltung (121, 163, 283) niedrigster Stufe zum weiteren Verzögern des von der ersten Einheitszeitverzögerungsschaltung niedrigster Stufe ausgegebenen verzögerten Multiplikationsergebnisses und zur Ausgabe dieses weiter verzögerten Multiplikationsergebnisses als Stufen-Ausgangssignal, das dem Stufen-Addierer der niedrigsten Stufe aus der Mehrzahl von Rückkopplungsstufen zugeführt wird.

4. Filter nach Anspruch 2 oder 3, bei dem der erste Addierer (102) das Ausgangssignal des Filters erzeugt und die erste Einheitszeitverzögerungsschaltung (103) das Ausgangssignal verzögert.

5. Filter nach Anspruch 2 oder 3, bei dem die erste Einheitszeitverzögerungsschaltung (272) das Ausgangssignal des Filters erzeugt.

6. Digitale Filteranordnung mit einem von einem zyklischen Filter nach Anspruch 2, 3, 4 oder 5 gebildeten Polstellenabschnitt und einem Nullstellenabschnitt,

wobei der Nullstellenabschnitt einen Eingang zur Aufnahme eines Eingangssignals (xn) sowie eine Mehrzahl von vorwärtsgekoppelten Stufe umfaßt, die parallel geschaltet sind und von denen jede in Kaskadenanordnung

EP 0 508 805 B1

aufweist:

einen mit dem Eingang verbundenen Koeffizientenmultiplizierer (81, 84, 88; 96) zum Multiplizieren des Eingangssignals mit einem jeweiligen Koeffizienten (dn), um ein Multiplikationsergebnis zu bilden, eine erste Stufen-Einheitszeitverzögerungsschaltung (82, 85, 89, ...98) zum Verzögern des Multiplikationsergebnisses, einen Stufen-Addierer (83, 86, 90, ... 95) zum Addieren des verzögerten Multiplikationsergebnisses zu dem Ausgangssignal der nächstniedrigeren Stufe, um ein entsprechendes Additionsergebnis zu bilden, und eine zweite Stufen-Einheitszeitverzögerungsschaltung (101, 87, 91, 95) zum Verzögern des Additionsergebnisses, um das Stufen-Ausgangssignal zu erzeugen,

wobei der Stufen-Addierer der höchsten Stufe ein Signal ausgibt, das die Summe aller Stufen-Ausgangssignale darstellt, und wobei die Anordnung so ausgebildet ist, daß alle aufeinanderfolgenden Rechenschaltungen des Filters durch Einheitszeitverzögerungen voneinander getrennt sind.

7. Anordnuna nach Anspruch 8. bei der die niedrigste der vorwärtsgekoppelten Stufen aufweist:

einen mit dem Eingang (xn) verbundenen Koeffizientenmultiplizierer (96) zum Multiplizieren des Eingangssignals mit einem Koeffizienten (dn), um ein Multiplikationsergebnis zu erzeugen, und erste und zweite Einheitszeitverzögerungsschaltungen (97, 98) zum Verzögern des Multiplikationsergebnisses, wobei das verzögerte Multiplikationsergebnis das Stufen-Ausgangssignal der niedrigsten Stufe darstellt.

8. Digitale Filteranordnung mit einem Polstellenabschnitt nach Anspruch 1 und einem Nullstellenabschnitt,

wobei das Filter einen Eingang zur Aufnahme eines Eingangssignals (xn) und eine Mehrzahl von parallel angeordneten Stufen umfaßt, die jeweils in Kaskade aufweisen:

einen mit dem Eingang verbundenen Koeffizientenmultiplizierer (41 - 51, 61) zum Multiplizieren des Eingangssignals (xn) mit einem entsprechenden Koeffizienten (dn), um ein Multiplikationsergebnis zu erzeugen, eine erste Stufen-Einheitszeitverzögerungsschaltung (41, 52, 62) zum Verzögern des Multiplikationsergebnisses, und ein entsprechendes Exemplar der Rückkopplungsschleifen (40, 50, 60), deren Addierer (43, 53, 63) das verzögerte Multiplikationsergebnis als Eingangssignal aufnimmt,

wobei die genannten Addiereinrichtungen (72, 71) in jeder Stufe mit Ausnahme der niedrigsten Stufe einen Stufen-Addierer aufweist zum Addieren des Ausgangssignals der Rückkopplungsschleife dieser Stufe zu dem verzögerten Ausgangssignal der Rückkopplungsschleife der nächstniedrigeren Stufe, um ein Additionsergebnis zu erzeugen, wobei die bzw. jede zwischen der höchsten und der niedrigsten Stufe liegende Stufe eine zweite Stufen-Einheitszeitverzögerungsschaltung zum Verzögern des Additionsergebnisses aufweist, um das genannte verzögerte Ausgangssignal zu erzeugen, und wobei die Anordnung so ausgebildet ist, daß alle aufeinanderfolgenden Rechenschaltungen des Filters durch Einheitszeitverzögerungen voneinander getrennt sind.

9. Digitales Filter nach Anspruch 8, bei dem die niedrigste Stufe einen mit dem Eingang verbundenen Koeffizientenmultiplizierer (61) aufweist zum Multiplizieren des Eingangssignals (xn) mit einem Koeffizienten (dn), um ein Multiplikationsergebnis zu erzeugen, ferner eine erste Stufen-Einheitszeitverzögerungsschaltung zum Verzögern des Multiplikationsergebnisses, ein entsprechendes Exemplar der Rückkopplungsschleifen (60) und eine zweite Stufen-Einheitszeitverzögerungsschaltung zum Verzögern des Ausgangssignals der Schleife, um das verzögerte Ausgangssignal der Stufe zu erzeugen.

**Revendications**

1. Un filtre numérique cyclique comprenant :
un ensemble de boucles de rétroaction (40, 50, 60) connectées en parallèle, chacune des boucles de cet ensemble

17

de boucles de rétroaction comprenant :

un additionneur (43, 53, 63) destiné à recevoir un signal d'entrée respectif et à soustraire du signal d'entrée respectif un signal de rétroaction retardé respectif, pour former un résultat de soustraction respectif,

un premier circuit de retard unité (44, 54, 64) connecté à l'additionneur pour retarder le résultat de soustraction et pour fournir en sortie le résultat de soustraction retardé, sous la forme d'un signal de sortie respectif de la boucle de rétroaction,

un multiplieur de coefficient (45, 55, 65) connecté au premier circuit de retard unité pour multiplier par un coefficient prédéterminé respectif (Cn) le résultat de soustraction retardé, pour former un signal de rétroaction respectif, et

un second circuit de retard unité (46, 56, 66) pour retarder le signal de rétroaction respectif qui est formé par le multiplieur de coefficient, pour fournir le signal de rétroaction retardé respectif à l'additionneur; et

des moyens (72, 71) pour additionner les signaux de sortie respectifs de l'ensemble de boucles de rétroaction; la configuration étant telle que tous les circuits arithmétiques successifs du filtre sont séparés par des retards unités.

2. Un filtre numérique cyclique comprenant :

un premier additionneur (102, 151, 271) pour recevoir un signal d'entrée et soustraire un signal de rétroaction de ce signal d'entrée, pour former un résultat de soustraction;

un premier circuit de retard unité (103, 152, 272) connecté au premier additionneur pour retarder le résultat de soustraction et pour fournir en sortie le résultat de soustraction retardé; et

un ensemble d'étages de rétroaction connectés en parallèle et en cascade, et comprenant chacun :

un multiplieur de coefficient (104, 108, 112, 116; 153, 157, 161; 273, 277, 281) connecté au premier circuit de retard unité pour multiplier par un coefficient prédéterminé respectif (gn) le résultat de soustraction retardé, de façon à former un résultat de multiplication respectif,

un premier circuit de retard unité d'étage (105, 109, 113, 117; 154, 158, 162; 274, 278, 282) pour retarder le résultat de multiplication respectif et pour fournir en sortie un résultat de multiplication retardé respectif,

un additionneur d'étage (106, 110, 114, 118; 155, 159; 275, 279) pour additionner le résultat de multiplication retardé respectif à un signal de sortie d'étage respectif qui est fourni par un étage de rétroaction immédiatement inférieur, pour former un résultat d'addition respectif, et

un second circuit de retard unité d'étage (107, 111, 115, 119; 156, 160; 276, 280) pour retarder le résultat d'addition respectif et pour fournir le résultat d'addition respectif retardé à titre de signal de sortie d'étage respectif;

dans lequel le premier additionneur (102, 151, 271) reçoit pour le signal de rétroaction le signal de sortie d'étage respectif qui est fourni par un étage de rang le plus élevé parmi l'ensemble d'étages de rétroaction; la configuration étant telle que tous les circuits arithmétiques successifs du filtre sont séparés par des retards unités.

3. Un filtre numérique cyclique selon la revendication 2, comprenant en outre un étage de rétroaction de rang le plus bas qui comprend :

un dernier multiplieur de coefficient (120, 161, 281) connecté au premier circuit de retard unité (103, 152, 272) pour multiplier le signal de sortie par un coefficient prédéterminé respectif, de façon à former un résultat de multiplication respectif;

un premier circuit de retard unité d'étage de rang le plus bas (122, 162, 282) pour retarder le résultat de multiplication qui est formé par le dernier multiplieur de coefficient, et pour fournir en sortie un résultat de multiplication retardé respectif; et

un second circuit de retard unité d'étage de rang le plus bas (121, 163, 283) pour retarder à nouveau le résultat de multiplication retardé qui est fourni en sortie par le premier circuit de retard unité d'étage de rang le plus bas, et pour fournir ce résultat de multiplication retardé à nouveau, sous la forme du signal de sortie d'étage respectif qui est appliqué à l'additionneur d'étage respectif d'un étage de rang le plus bas de l'ensemble d'étages de rétroaction.

4. Un filtre selon la revendication 2 ou 3, dans lequel le premier additionneur (102) forme le signal de sortie du filtre et le premier retard unité (103) retarde le signal de sortie.

5. Un filtre selon la revendication 2 ou 3, dans lequel le premier retard unité (272) forme le signal de sortie du filtre.

6. Une structure de filtre numérique comprenant une section de pale qui est formée par un filtre cyclique conforme à la revendication 2, 3, 4 ou 5, et une section de zéro, dans laquelle la section de zéro comprend une entrée qui est destinée à recevoir un signal d'entrée (xn) et un ensemble d'étages d'action directe connectés en parallèle, et comprenant chacun, en cascade :

> un multiplieur de coefficient (81, 84, 88; 96) connecté à l'entrée (xn) pour multiplier le signal d'entrée par un coefficient respectif (dn) de façon à former un résultat de multiplication,
> un premier retard unité d'étage (82, 85, 89, ...98) ... 98) pour retarder le résultat de multiplication,
> un additionneur d'étage (83, 86, 90, ... 95) pour additionner le résultat de multiplication retardé au signal de sortie de l'étage immédiatement inférieur, de façon à former un résultat d'addition, et
> un second retard unité d'étage (101, 87, 91, 95) pour retarder le résultat d'addition de façon à former le signal de sortie d'étage; dans laquelle l'additionneur d'étage de l'étage de rang le plus élevé fournit en sortie un signal qui est la sommation de tous les signaux de sortie d'étage, la configuration étant telle que tous les circuits arithmétiques successifs de la structure de filtre sont séparés par des retards unités.

7. Une structure selon la revendication 8, dans laquelle l'étage d'action directe de rang le plus bas comprend :

> un multiplieur de coefficient (96) connecté à l'entrée (xn) pour multiplier le signal d'entrée par un coefficient (dn), pour former un résultat de multiplication,
> des premier et second retards unités (97, 98) pour retarder le résultat de multiplication, le résultat de multiplication retardé étant le signal de sortie d'étage de l'étage de rang le plus bas.

8. Une structure de filtre numérique comprenant une section de pôle conforme à la revendication 1 et une section de zéro, dans laquelle le filtre comprend une entrée destinée à recevoir un signal d'entrée (xn) et un ensemble d'étages connectés en parallèle, comprenant chacun, en cascade :

> un multiplieur de coefficient (41 - 51, 61) connecté à l'entrée pour multiplier le signal d'entrée (xn) par un coefficient respectif (dn), pour former un résultat de multiplication,
> un premier retard unité d'étage (42, 52, 62) pour retarder le résultat de multiplication,
> l'une respective des boucles de rétroaction (40, 50, 60) dont l'additionneur (43, 53, 63) reçoit le résultat de multiplication retardé, pour le signal d'entrée respectif de cette boucle, les moyens pour additionner (71, 72) comprenant dans chaque étage, à l'exception de l'étage de rang le plus bas, un additionneur d'étage pour additionner le signal de sortie de la boucle de rétroaction de cet étage à un signal de sortie retardé de la boucle de rétroaction de l'étage immédiatement inférieur, de façon à former un résultat d'addition, l'étage ou chaque étage se trouvant entre l'étage de rang le plus élevé et celui de rang le plus bas, ayant un second retard unité d'étage pour retarder !e résultat d'addition de façon à former le signal de sortie retardé, la configuration étant telle que tous les étages arithmétiques successifs de la structure de filtre sont séparés par des retards unités.

9. Un filtre numérique selon la revendication 8, dans lequel l'étage de rang le plus bas comprend un multiplieur de coefficient (61) qui est connecté à l'entrée pour multiplier le signal d'entrée (xn) par un coefficient (dn), pour former un résultat de multiplication, un. premier retard unité d'étage pour retarder le résultat de multiplication, l'une respective des boucles de rétroaction (60) et un second retard élémentaire d'étage pour retarder le signal de sortie de la boucle de façon à former le signal de sortie retardé de l'étage.

EP 0 508 805 B1

FIG. 1

FIG. 2

FIG. 3

# FIG. 4

EP 0 508 805 B1

FIG. 5

xn, yn, 103, 102, 101, 83, 87, 86, 91, 90, 80a, 100a

81 h0, 84 h1, 88 h2, 92 hM+2, 96 hM+3

82, 85, 89, 93, 98, 97, 94, 95

104 g3, 108 g4, 112 g5, 116 gN+2, 120 gN+3

105, 109, 113, 117, 122, 121

106, 110, 114, 118, 107, 111, 115, 119

# F I G. 6

FIG. 7

# FIG. 8

# FIG. 9

# FIG. 10

# FIG. 11

FIG. 12

# FIG. 13